# EUROPEAN PATENT SPECIFICATION

(11) **EP 4 073 884 B1**
(45) Date of publication and mention of the grant of the patent: **14.10.2026**
(21) Application number: 19832577.1
(22) Date of filing: 12.12.2019
(51) Int. Cl.: H01Q 3/26, H04B 17/12, H04B 17/21, G01R 29/10

(54) **OVER THE AIR CALIBRATION OF AN ADVANCED ANTENNA SYSTEM**
OVER-THE-AIR-KALIBRIERUNG EINES FORTSCHRITTLICHEN ANTENNENSYSTEMS
ÉTALONNAGE PAR LIAISON RADIO D'UN SYSTÈME D'ANTENNE AVANCÉ

(43) Date of publication of application: 19.10.2022
(73) Proprietor: TELEFONAKTIEBOLAGET LM ERICSSON (PUBL), 164 83 Stockholm (SE)
(72) Inventor: JIDHAGE, Henrik, 43654 Hovås (SE); JOHANSSON, Stefan, 44292 Romelanda (SE); LIEBACK, Tomas, 435 32 Mölnlycke (SE)
(74) Representative: Ericsson
(86) International application number: PCT/EP2019/084816
(87) International publication number: WO 2021/115599

(56) References cited:
- WO-A1-2017/202469
- HYUNG GEUN PARK ET AL: "Model based antenna array calibration for digital beamforming systems", VTC 2003-SPRING. THE 57TH. IEEE SEMIANNUAL VEHICULAR TECHNOLOGY CONFERENCE. PROCEEDINGS. JEJU, KOREA, APRIL 22 - 25, 2003; [IEEE VEHICULAR TECHNOLGY CONFERENCE], NEW YORK, NY : IEEE, US, vol. 2, 22 April 2003 (2003-04-22), pages 867 - 870, XP010862554, ISBN: 978-0-7803-7757-8, DOI: 10.1109/VETECS.2003.1207749
- MIGUEL ALEJANDRO SALAS-NATERA ET AL: "Procedure for Measurement, Characterization, and Calibration of Active Antenna Arrays", IEEE TRANSACTIONS ON INSTRUMENTATION AND MEASUREMENT, IEEE SERVICE CENTER, PISCATAWAY, NJ, US, vol. 62, no. 2, 27 September 2012 (2012-09-27), pages 377 - 391, XP011484672, ISSN: 0018-9456, DOI: 10.1109/TIM.2012.2217662
- GALINA BABUR ET AL: "SIMPLE CALIBRATION TECHNIQUE FOR PHASED ARRAY RADAR SYSTEMS", PROGRESS IN ELECTROMAGNETICS RESEARCH M, vol. 55, 31 December 2017 (2017-12-31), pages 109 - 119, XP055644836, DOI: 10.2528/PIERM16101203

## Description

### TECHNICAL FIELD

Embodiments presented herein relate to a method, a test equipment, a computer program, and a computer program product for over the air (OTA) calibration of an advanced antenna system, or active antenna system, (AAS).

### BACKGROUND

AAS commonly require control of phase and amplitude excitations of each antenna element or subarray. In most cases this implies that the AAS needs accurate calibration.

Assuming that the hardware of the AAS is stable over time, i.e. that the phase and amplitude of the radio chains will not vary over time, it might be sufficient that a one-time calibration is performed for the AAS. However, with a highly integrated building practice no connector interfaces suitable for calibration will be accessible and thus the calibration needs to be performed OTA.

However, in most cases the hardware of the AAS cannot be assumed stable over time. Therefore, the hardware might comprise a built-in calibration functionality to enable repeatable calibrations of AAS in field. This calibration capability might be based on, for instance, a built-in calibration network or by making use of mutual coupling between the antenna elements in the array aperture of the AAS. However, to ensure high accuracy of the built-in calibration, there is often a need for an accurate OTA calibration to calibrate the built-in calibration functionality.

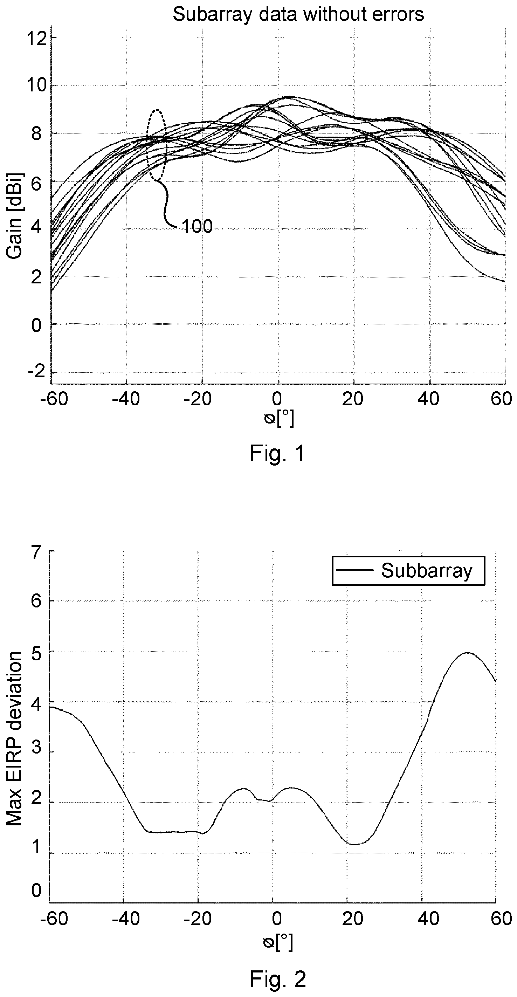

**Fig. 1** shows the horizontal embedded subarray antenna patterns and **Fig. 2** shows the maximum gain deviation (per ϕ direction) for an AAS having 16 subarrays. It is desired to minimize the gain deviation between the subarray antenna patterns in order to minimize excitation errors which can cause e.g. poor sidelobes or incorrect beam shapes. The variation between the patterns in Fig. 1 can be explained by mutual coupling, edge effects, etc. and some variations need to be accepted given a certain antenna.

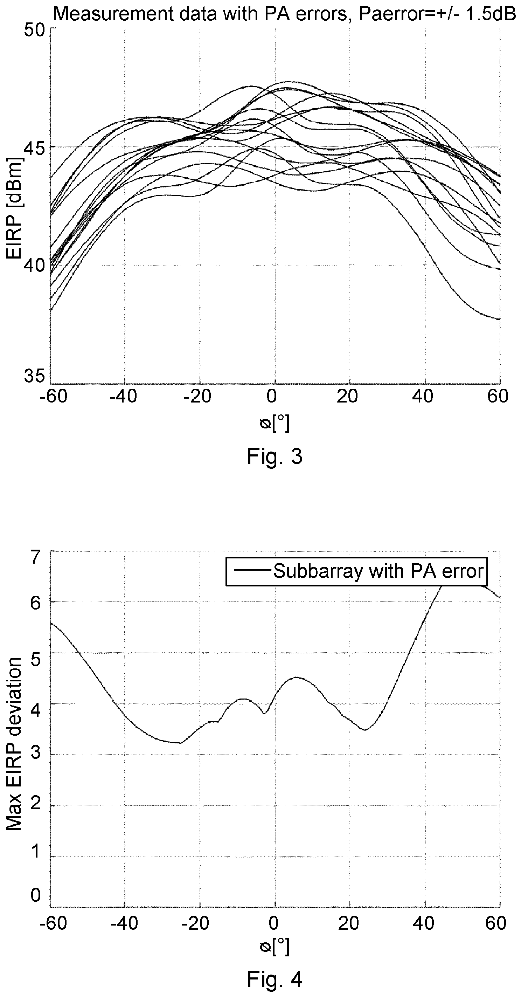

Different power amplifier output power will offset the curves and cause an increase gain deviation which needs to be calibrated. **Fig. 3** shows Equivalent Isotropically Radiated Power (EIRP) levels assuming radio branches with 5W nominal power and a random uniform power error of +/-1.5 dB i.e. 37 dBm+/-1.5 dB output power. **Fig. 4** shows the corresponding maximum EIRP deviation (per ϕ direction). The deviation is increased in Fig. 4 compared to Fig. 2.

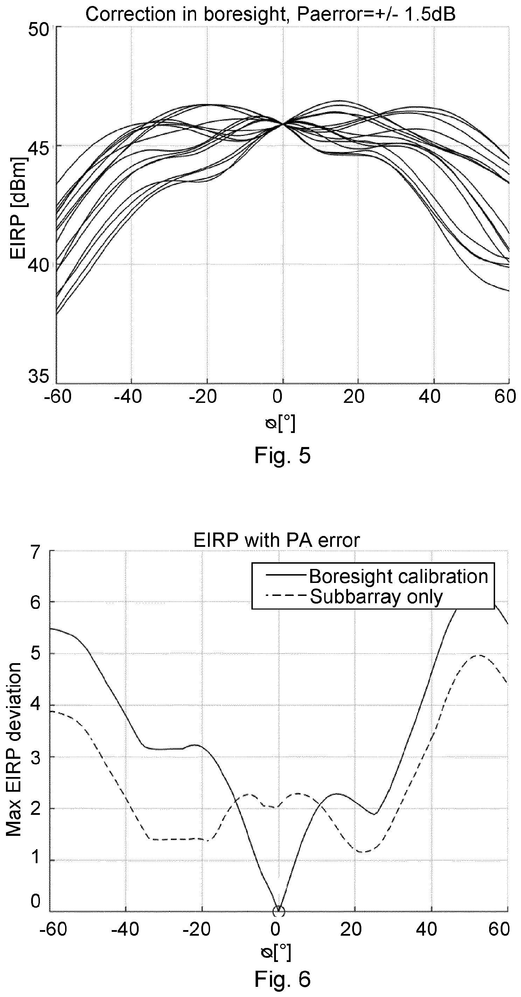

Current OTA calibration methods measure the EIRP in one direction e.g. *ϕ* = 0°. Measurement values are used to calculate a compensation factor. One example of the resulting EIRP patterns after amplitude corrections having been applied is presented in **Figs. 5** and **6****.** From these figures follows that there is no EIRP deviation in the calibration direction *ϕ* = 0° (assuming no calibration error) and but potentially very large EIRP deviation in other directions.

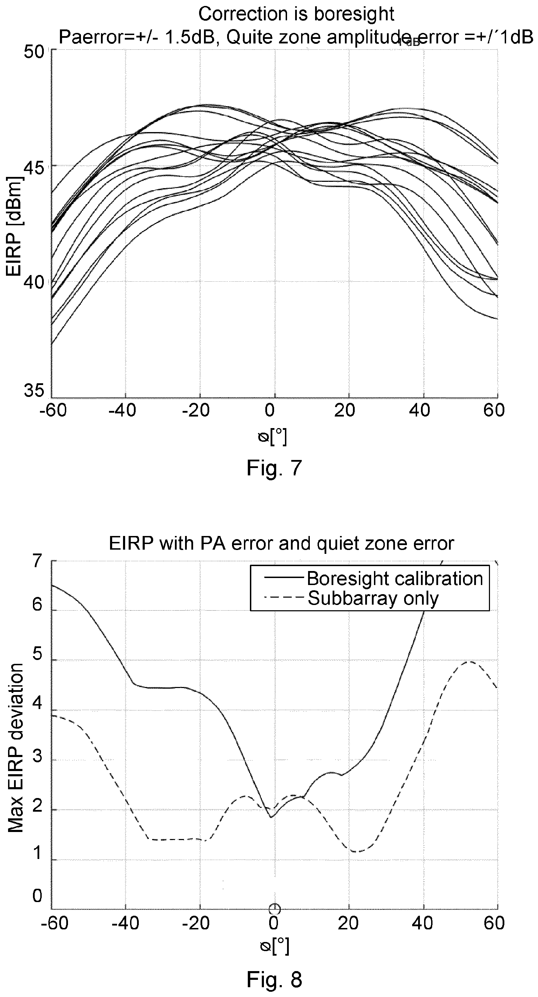

Current OTA calibration methods are also sensitive to measurement errors, e.g. reflections in the antenna test range. **Figs. 7** and **8** show the EIRP after calibration assuming a random uniform quiet zone amplitude error of +/- 1 dB. From these figures follows that it is possible that the EIRP deviation might increase in all directions.

Hyung Geun Park et al: "Model based antenna array calibration for digital beamforming systems", Proc. 57th IEEE Semiannual Vehicle Techn. Conf., 22 April 2003, pp 867-870, DOI 10.1109/VETECS.2003.1207749 relates to a model based calibration algorithm to remove antenna array effects for a digital beamforming system.

M. A. Salas-Natera et al: "Procedure for Measurement, Characterization, and Calibration of Active Antenna Arrays", IEEE Trans. Instr. And Meas., Vol. 62, No. 2, 1 February 2013, pp 377-391 discloses a calibration procedure is based on an active antenna array model and derivation of the scattering matrix from the active element pattern. The algorithm deals with mutual coupling effects and gain and phase errors.

It is noted that although the above examples in Figs. 1-8 are performed for amplitude errors, corresponding results are obtainable for phase errors.

In view of the results shown in Figs. 1-8 there is still a need for improved OTA calibration of an AAS.

### SUMMARY

An object of embodiments herein is to provide efficient OTA calibration of an AAS, not suffering from the issues noted above, or at least where the above issues have been mitigated or reduced.

According to a first aspect there is presented a method for OTA calibration of an AAS. The AAS comprises *N* antenna branches, each of which comprises a respective subarray. The subarray of each antenna branch has a subarray antenna pattern extending over an angular interval. The method is performed by a test equipment. The method comprises obtaining measurement values for each of the antenna branches. At least one measurement value is obtained per each antenna branch. The method comprises determining one calibration factor value per antenna branch using the measurement values and taking the subarray antenna patterns into account. Each of the antenna branches is coupled to a transmitter and a receiver that are affected by the calibration factor value. The method comprises applying the determined calibration factor values to the *N* antenna branches, thereby calibrating the AAS.

According to a second aspect there is presented a test equipment for OTA calibration of an AAS. The AAS comprises N antenna branches, each of which comprises a respective subarray. The subarray of each antenna branch has a subarray antenna pattern extending over an angular interval. The test equipment comprises processing circuitry. The processing circuitry is configured to cause the test equipment to obtain measurement values for each of the antenna branches. At least one measurement value is obtained per each antenna branch. The processing circuitry is configured to cause the test equipment to determine one calibration factor value per antenna branch using the measurement values and taking the subarray antenna patterns into account. Each of the antenna branches is coupled to a transmitter and a receiver that are affected by the calibration factor value. The processing circuitry is configured to cause the test equipment to apply the determined calibration factor values to the N antenna branches, thereby calibrating the AAS.

According to a third aspect there is presented a test equipment for OTA calibration of an AAS. The AAS comprises N antenna branches, each of which comprises a respective subarray. The subarray of each antenna branch has a subarray antenna pattern extending over an angular interval. The test equipment comprises an obtain module configured to obtain measurement values for each of the antenna branches. At least one measurement value is obtained per each antenna branch. The test equipment comprises a determine module configured to determine one calibration factor value per antenna branch using the measurement values and taking the subarray antenna patterns into account. Each of the antenna branches is coupled to a transmitter and a receiver that are affected by the calibration factor value. The test equipment comprises an apply module configured to apply the determined calibration factor values to the N antenna branches, thereby calibrating the AAS.

According to a fourth aspect there is presented a computer program for OTA calibration of an AAS, the computer program comprising computer program code which, when run on a test equipment, causes the test equipment to perform a method according to the first aspect.

According to a fifth aspect there is presented a computer program product comprising a computer program according to the fourth aspect and a computer readable storage medium on which the computer program is stored. The computer readable storage medium could be a non-transitory computer readable storage medium.

Advantageously, these aspects provide efficient OTA calibration of the AAS.

Advantageously, the provided OTA calibration of the AAS does not suffer from the issues noted above.

Other objectives, features and advantages of the enclosed embodiments will be apparent from the following detailed disclosure, from the attached dependent claims as well as from the drawings.

Generally, all terms used in the claims are to be interpreted according to their ordinary meaning in the technical field, unless explicitly defined otherwise herein. All references to "a/an/the element, apparatus, component, means, module, step, etc." are to be interpreted openly as referring to at least one instance of the element, apparatus, component, means, module, step, etc., unless explicitly stated otherwise. The steps of any method disclosed herein do not have to be performed in the exact order disclosed, unless explicitly stated.

### BRIEF DESCRIPTION OF THE DRAWINGS

The inventive concept is now described, by way of example, with reference to the accompanying drawings, in which:
Figs. 1-8 show simulation results according to state of the art;
Fig. 9 is a schematic diagram illustrating a communications network according to embodiments;
Fig. 10 is a flowchart of methods according to embodiments;
Figs. 11-23 show simulation results according to embodiments;
Fig. 24 is a schematic diagram showing functional units of a test equipment according to an embodiment;
Fig. 25 is a schematic diagram showing functional modules of a test equipment according to an embodiment; and
Fig. 26 shows one example of a computer program product comprising computer readable storage medium according to an embodiment.

### DETAILED DESCRIPTION

The inventive concept will now be described more fully hereinafter with reference to the accompanying drawings, in which certain embodiments of the inventive concept are shown. This inventive concept may, however, be embodied in many different forms and should not be construed as limited to the embodiments set forth herein; rather, these embodiments are provided by way of example so that this disclosure will be thorough and complete, and will fully convey the scope of the inventive concept to those skilled in the art. Like numbers refer to like elements throughout the description. Any step or feature illustrated by dashed lines should be regarded as optional. Equations are given in both linear and decibel (dB) scale. It is well known in the literature how to, as such, transform between equations in linear scale on the one hand and equations in dB scale on the other hand.

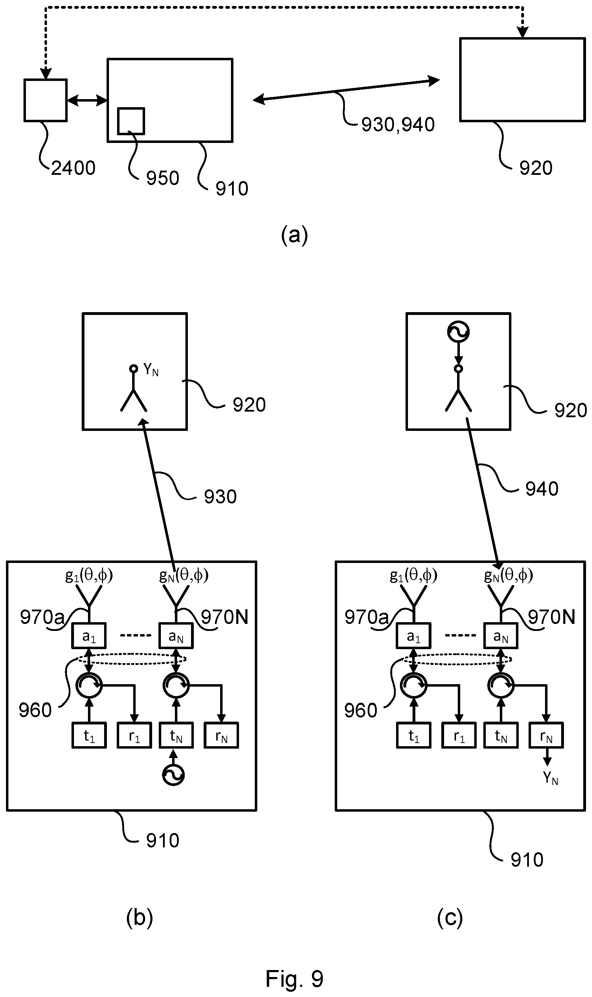

Fig. 9 at (a), (b), and (c) illustrate examples of schematic diagrams of a test environment 900, where embodiments presented herein can be applied. **Fig. 9(a)** shows a general overview of the test environment 900. The test environment 900 comprises an AAS 910. The AAS 910 is configured to transmit radio signals 930 to, and to receive radio signals 940 from, a remote signal transmitter and receiver 920. The remote signal transmitter and receiver 920 at least comprises a test range antenna for receiving radio signals 930 and for transmitting radio signals 940. The AAS 910 is operatively connected to a test equipment 2400. The test equipment 2400 is configured for OTA calibration of the AAS 910. The AAS 910 therefore comprises a calibration unit 950 for interaction with the test equipment 2400. In some scenarios the test equipment 2400 is also operatively connected to the remote signal transmitter and receiver 920 for receiving signal from the remote signal transmitter and receiver 920 as transmitted from the AAS 910 and/or for providing the remote signal transmitter and receiver 920 with signals to be transmitted towards the AAS 910.

Fig. 9(b) and Fig. 9(c) show more details of the test environment. **Fig. 9(b)** illustrates where the AAS 910 is in transmit mode and **Fig. 9(c)** illustrates where the AAS 910 is in receive mode. As illustrated in Figs. 9(b) and 9(c), the AAS 910 comprises *N* antenna branches 960. Each of the *N* antenna branches 960 comprises a respective subarray 970a:970N. As in Fig. 9(b) and Fig. 9(b), in some examples, each subarray comprises at least one individual antenna element. The subarray 970a:970N of each antenna branch gives rise to a subarray antenna pattern 100; *g*₁(*θ*, *ϕ*), *g*₂(*θ*, *ϕ*), ..., *g_{N}*(*θ, ϕ*) extending over an angular interval (not shown).

Each of the *N* antenna branches 960 is coupled to a transmitter *tₙ* and a receiver *rₙ*, where *n = 1... N.* The transmitter *tₙ* and the receiver *rₙ* are affected by calibration factor values *c_{n,dB}*, *c_{n,deg}* as determined by the test equipment 2400.

Traditionally, measurement values *Yₙ* are used to calculate the compensation factor, *c_{n,dB}* relative a desired reference level *Y_{ref}*, according to: ${c}_{n , dB} = {Y}_{ref , dB} - {Y}_{n , dB}$

However, as noted above there is still a need for improved OTA calibration of an AAS 910. Embodiments, aspects, and examples, of how the test equipment 2400 might determine the calibration factor values *c_{n,dB}*, *c_{n,deg}* will therefore be disclosed below.

In more detail, current calibration functions do not take amplitude and phase variations of the embedded subarray antenna patterns into account. As a result thereof, high gain deviations might occur for other directions than the calibrated direction (i.e., for other values of *ϕ* than for the value of *ϕ* for which the calibration was made; typically the calibration is made for *ϕ* = 0). Further, current calibration functions might be sensitive to, for example, quiet zone errors when calibration only is performed in one direction. At least some of the herein disclosed embodiments are therefore based on taking into account the effects of amplitude and phase variations of the individual embedded subarray antenna patterns to achieve proper calibration.

At least some of the herein disclosed embodiments therefore aim to reduce calibration errors due to the fact that the embedded antenna patterns of the individual antenna elements or subarray varies depending on its position in the full antenna array. If this is not properly handled this effect might cause significant residual errors in the calibration. At least some of the herein disclosed embodiments aim to reduce calibration errors due to a non-perfect quite zone for the OTA calibration, i.e. where disturbances caused by unwanted reflections in, for instance, an anechoic test chamber. At least some of the herein disclosed embodiments are therefore applicable to reduce calibration errors due to non-perfect quite zones for the OTA calibration.

The embodiments disclosed herein in particular relate to mechanisms for OTA calibration of an AAS 910. In order to obtain such mechanisms, there is provided a test equipment 2400, a method performed by the test equipment 2400, a computer program product comprising code, for example in the form of a computer program, that when run on a test equipment 2400, causes the test equipment 2400 to perform the method.

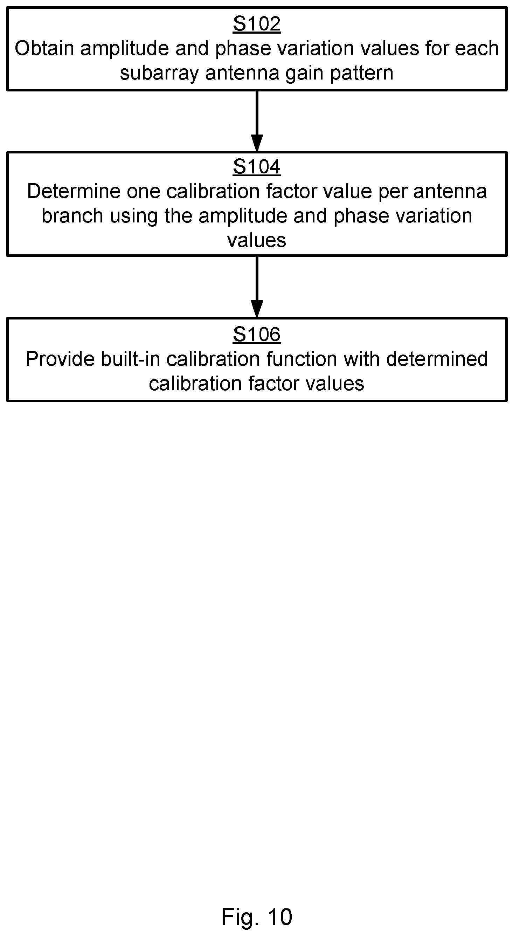

**Fig. 10** is a flowchart illustrating embodiments of methods for OTA calibration of an AAS 910. The AAS 910 is assumed to comprise N antenna branches 960, each of which comprises a respective subarray 970a:970N. The subarray of each antenna branch gives rise to a subarray antenna pattern 100; *g*₁(*θ*, *ϕ*), *g*₂(*θ*, *ϕ*), ..., *g_{N}*(*θ, ϕ*) extending over an angular interval. The methods are performed by the test equipment 2400. The methods are advantageously provided as computer programs 2620.

S102: The test equipment 2400 obtains measurement values for each of the antenna branches, At least one measurement value is obtained per each antenna branch.

S104: The test equipment 2400 determines one calibration factor value *c_{n,dB}*, *c_{n,deg}* per antenna branch using the measurement values and takes the subarray antenna patterns 100; *g*₁(*θ, ϕ*), *g*₂(*θ*, *ϕ*), ..., *g_{N}*(*θ, ϕ*) into account.

S106: The test equipment 2400 applies the determined calibration factor values to the N antenna branches 960. The test equipment 2400 thereby calibrates the AAS 910.

Advantageously, this method provides efficient OTA calibration of the AAS 910.

Advantageously, the provided OTA calibration of the AAS 910 does not suffer from the issues noted in the background section.

Embodiments relating to further details of OTA calibration of an AAS 910 as performed by the test equipment 2400 will now be disclosed.

There may be different types of measurement values. In some examples, the measurement values pertain to at least one of amplitude and phase.

The herein disclosed methods for OTA calibration of the AAS 910 are applicable to different types of scenarios. Embodiments, aspects, and examples relating to these scenarios will now be disclosed in turn.

According to a first scenario the subarray antenna patterns are known to the test equipment 2400 and all measurement values are obtained from one and the same direction within the angular interval.

Particularly, according to an embodiment, the subarray antenna patterns are known to the test equipment 2400, and, according to an embodiment, all measurement values are obtained from one and the same direction within the angular interval.

Further details of the first scenario will now be disclosed.

If the subarray antenna pattern, *gₙ*, is known in the calibration direction(s), compensation might be performed taking the actual gain/phase into consideration. Particularly, according to an embodiment, the calibration factor value *c_{n,dB}*, *c_{n,deg}* per antenna branch is determined as a function of a reference signal value given by *Y_{ref}*, the subarray antenna pattern for the subarray of antenna branch n in direction *ϕ* given by ${g}_{n} \left({ϕ}_{cal}^{m}\right)$, and a received signal value for antenna branch *n* in direction *ϕ* given by ${Y}_{n} \left({ϕ}_{cal}^{m}\right)$. In terms of amplitude variation, the calibration factor value for antenna branch n might thus be determined as: ${c}_{n , dB} = 20 log \left|\frac{{Y}_{ref} ⋅ {g}_{n} \left({ϕ}_{cal}^{m}\right)}{{Y}_{n} \left({ϕ}_{cal}^{m}\right)}\right|$

Further, in terms of phase variation, the calibration factor value for antenna branch n might be determined as: ${c}_{n , deg} = arg \left(\frac{{Y}_{ref} ⋅ {g}_{n} \left({ϕ}_{cal}^{m}\right)}{{Y}_{n} \left({ϕ}_{cal}^{m}\right)}\right)$

This will create a performance according to Figs. 1 and 2 but with power amplifier errors only (i.e., without any quiet zone errors being added).

According to a second scenario the subarray antenna patterns are known to the test equipment 2400 and measurement values for each of the subarray antenna patterns are obtained from one and the same set of directions. The set of directions is composed of at least two directions within the angular interval.

That is, according to an embodiment, measurement values for each of the subarray antenna patterns are obtained from one and the same set of directions, where the set of directions is composed of at least two directions within the angular interval.

Further details of the second scenario will now be disclosed.

Using measurements in more than one direction M > 1 might reduce the impact of quiet zone errors. Particularly, according to an embodiment, in terms of amplitude variation, the calibration factor value *c_{n,dB}* for antenna branch *n* is determined as a function of magnitude of a received signal value of the measurement values for antenna branch n in a direction *ϕ* given by ${Y}_{n , dB} \left({ϕ}_{cal}^{m}\right)$, the amplitude-wise subarray antenna pattern for subarray *n* in a direction *ϕ* given by ${g}_{n , dB} \left({ϕ}_{cal}^{m}\right)$, and an amplitude-wise reference signal value given by *P_{ref,dB}*. In terms of amplitude variation, the calibration factor value *c_{n,dB}* for antenna branch *n* might thus be determined by minimizing a cost function *S*(*c_{n,dB}*) given as (with values in dB), where the summation is to m *= M:* $S \left({c}_{n , dB}\right) = {\sum }_{m = 1}^{M} {\left(\left|{Y}_{n , dB}\left({ϕ}_{cal}^{m}\right)+{c}_{n , dB}-{g}_{n , dB}\left({ϕ}_{cal}^{m}\right)-{P}_{ref , dB}\right|\right)}^{2}$

The calibration factor values might be solved with, for example, a least squares optimization.

Further, in terms of phase variation, the calibration factor value *c_{n,deg}* for antenna branch *n* is, according to an embodiment, determined as a function of a phase-wise received signal value of the measurement values for antenna branch *n* in a direction *ϕ* given by ${Y}_{n , deg} \left({ϕ}_{cal}^{m}\right)$, the phase-wise subarray antenna pattern for the subarray of antenna branch n in a direction *ϕ* given by ${g}_{n , deg} \left({ϕ}_{cal}^{m}\right)$, and a phase-wise reference signal value given by *P_{ref,deg}*. Thus, in terms of phase variation, the calibration factor value *c_{n,deg}* for antenna branch *n* might be determined by minimizing a cost function *S*(*c_{n,deg}*) given as (with values in degrees), where the summation is to m = M: $S \left({c}_{n , deg}\right) = {\sum }_{m = 1}^{M} {\left(\left|{Y}_{n , deg}\left({ϕ}_{cal}^{m}\right)+{c}_{n , deg}-{g}_{n , deg}\left({ϕ}_{cal}^{m}\right)-{P}_{ref , deg}\right|\right)}^{2}$

The calibration factor values might be solved with, for example, a least squares optimization.

According to a third scenario the subarray antenna patterns are unknown to the test equipment 2400, and the measurement values are of amplitude and/or phase values in at least two directions within the angular interval. The subarray antenna patterns are then represented by these amplitude and/or phase values.

Using measurements in more than one direction *M* > 1 might enable the average error over the angular interval to be minimized according to some arbitrary metric.

Further details of the third scenario will now be disclosed.

Particularly, according to an embodiment, in terms of amplitude variation, the calibration factor value *c_{n,dB}* for antenna branch *n* is determined as a function of magnitude of a received signal value of the measurement values for antenna branch *n* in a direction *ϕ* given by ${Y}_{n , dB} \left({ϕ}_{cal}^{m}\right)$ and an amplitude-wise reference signal value in a direction *ϕ* given by ${Y}_{ref , dB} \left({ϕ}_{cal}^{m}\right)$. Thus, in terms of amplitude variation, the calibration factor value *c_{n,dB}* for antenna branch *n* might be determined by minimizing a cost function *S*(*c_{n,dB}*) given as (with values in dB), where the summation is to m *= M:* $S \left({c}_{n , dB}\right) = {\sum }_{m = 1}^{M} {\left(\left|{Y}_{n , dB}\left({ϕ}_{cal}^{m}\right)+{c}_{n , dB}-{Y}_{ref , dB}\left({ϕ}_{cal}^{m}\right)\right|\right)}^{2}$

The calibration factor values might be solved with, for example, a least squares optimization. This might enable the average error over the angular interval to be minimized.

Simulation results relevant for amplitude aspects will now be presented.

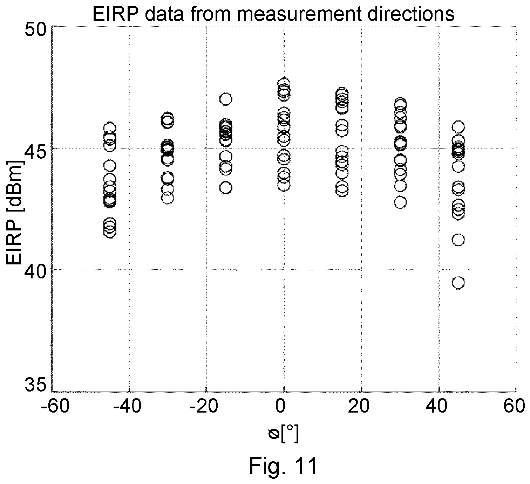

Fig. 11 shows measurements results in 7 directions, for *ϕ* = -45°: 15°: +45°, with power amplifier errors only (i.e., not having any quiet zone error). Such measurements might be performed for one representative unit if the variations for the different directions are systematic. The calibration factor values might be calculated from the EIRP measurements in Fig. 11 by minimizing the amplitude deviation of all directions by applying a correction factor to the individual antenna branches.

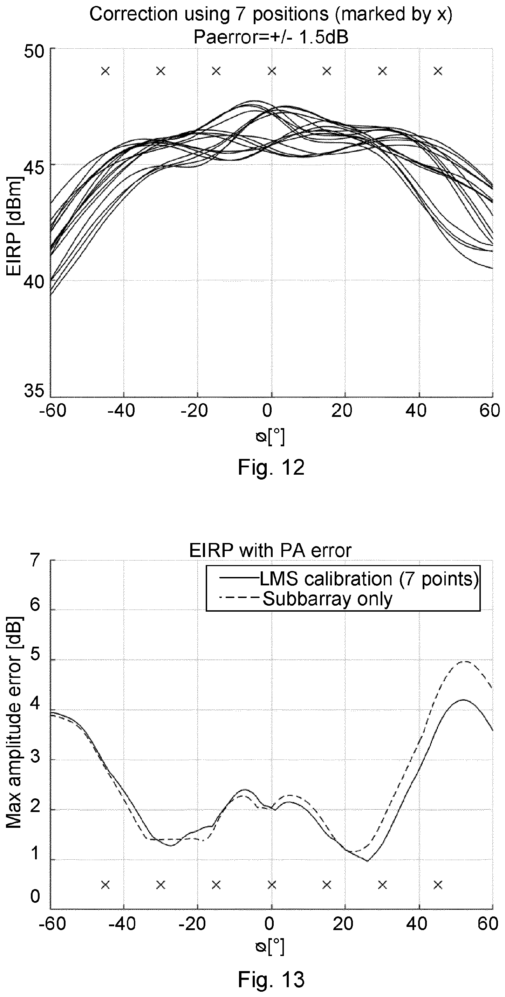

**Fig. 12** shows the EIRP patterns and **Fig. 13** shows the EIRP deviation after calibration in 7 directions. Here it is possible to see that the EIRP deviation is close to the original gain deviation of the subarrays i.e. an improvement compared to boresight calibration.

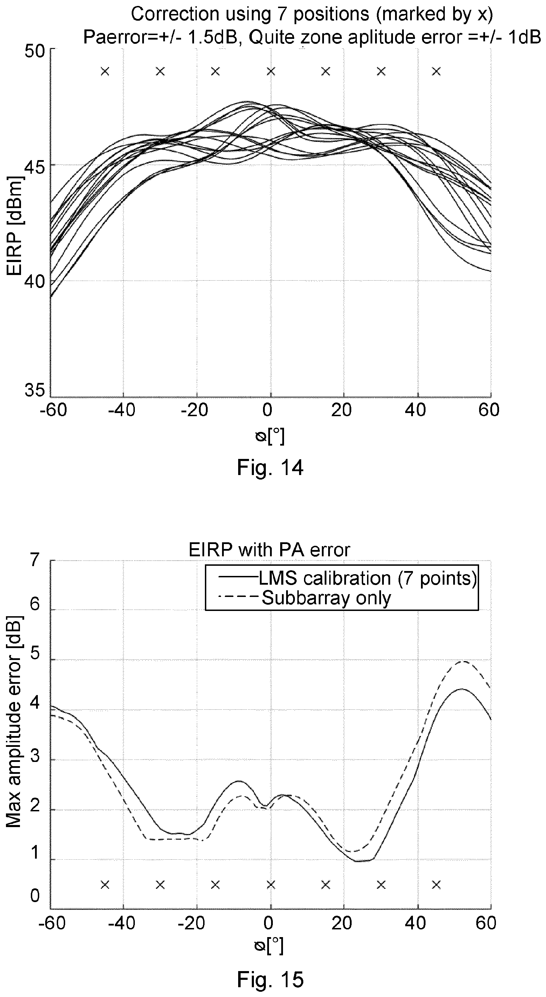

**Fig. 14** and **Fig. 15** show results corresponding to those in Fig. 12 and Fig. 13, respectively, but where a quiet zone amplitude error of +/- 1 dB has been added.

In terms of phase variation, the calibration factor value *c_{n,deg}* for antenna branch *n* is, according to an embodiment, determined as a function of a phase-wise received signal value of the measurement values for antenna branch *n* in a direction *ϕ* given by ${Y}_{n , deg} \left({ϕ}_{cal}^{m}\right)$ and a phase-wise reference signal value in a direction *ϕ* given by ${Y}_{ref , deg} \left({ϕ}_{cal}^{m}\right)$. Thus, in terms of phase variation, the calibration factor value *c_{n,deg}* for antenna branch *n* might be determined by minimizing a cost function *S*(*c_{n,deg}*) given as (with values in dB), where the summation is to *m = M:* $S \left({c}_{n , deg}\right) = {\sum }_{m = 1}^{M} {\left(\left|{Y}_{n , deg}\left({ϕ}_{cal}^{m}\right)+{c}_{n , deg}-{Y}_{ref , deg}\left({ϕ}_{cal}^{m}\right)\right|\right)}^{2}$

The calibration factor values might be solved with, for example, a least squares optimization. This might enable the average error over the angular interval to be minimized.

Simulation results relevant for phase aspects will now be presented.

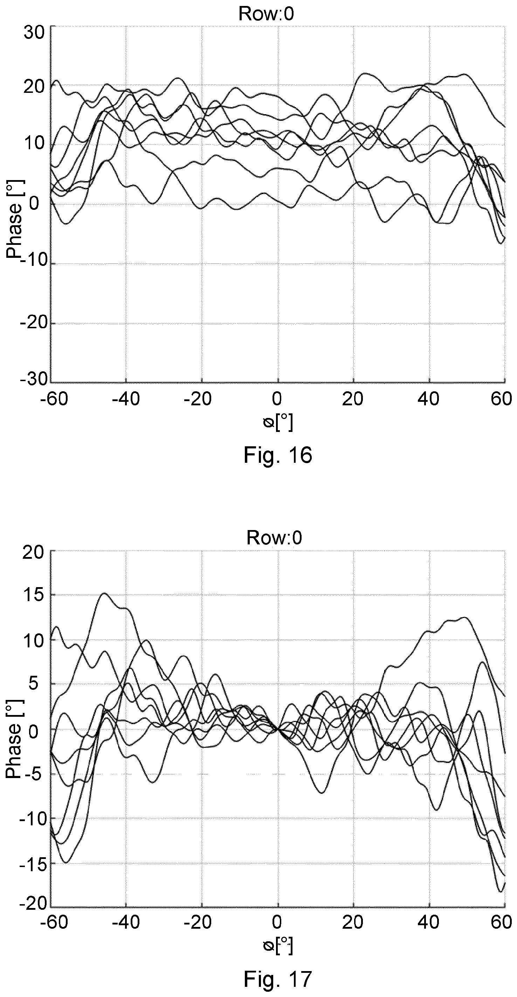

**Fig. 16** shows the uncalibrated phase for an AAS 910 with N = 8 subarrays and where phase centers have been moved to generate a "flat" phase over the angular interval. This can be accomplished by calculating the individual phase centers of the different subarrays and thereafter moving the subarrays.

**Fig. 17** shows the phase variation when the calibration is performed in boresight.

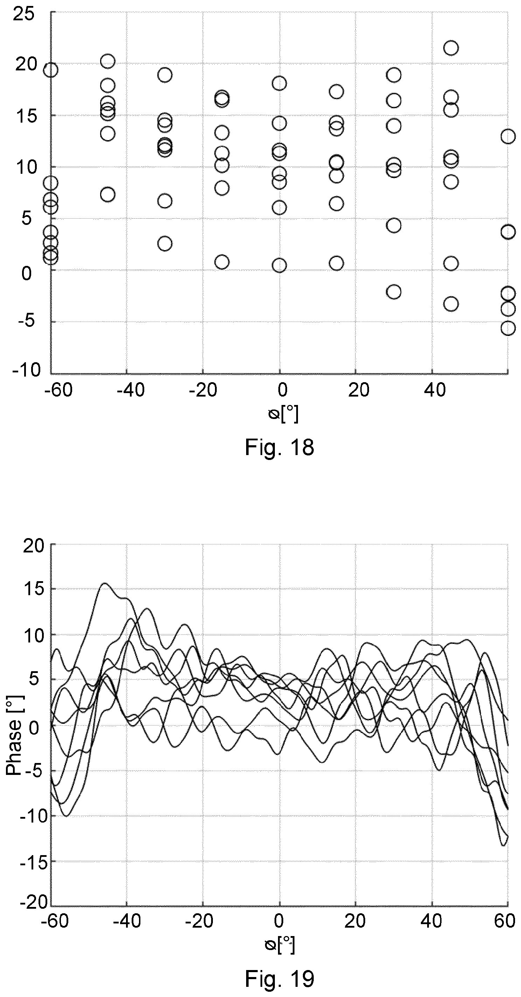

**Fig. 18** shows measurements results in 9 directions for *ϕ* = -60°: 15°: +60°.

**Fig. 19** shows the resulting phase error when calibration factor values resulting from least squares optimization in the 9 directions of Fig. 18 has been applied.

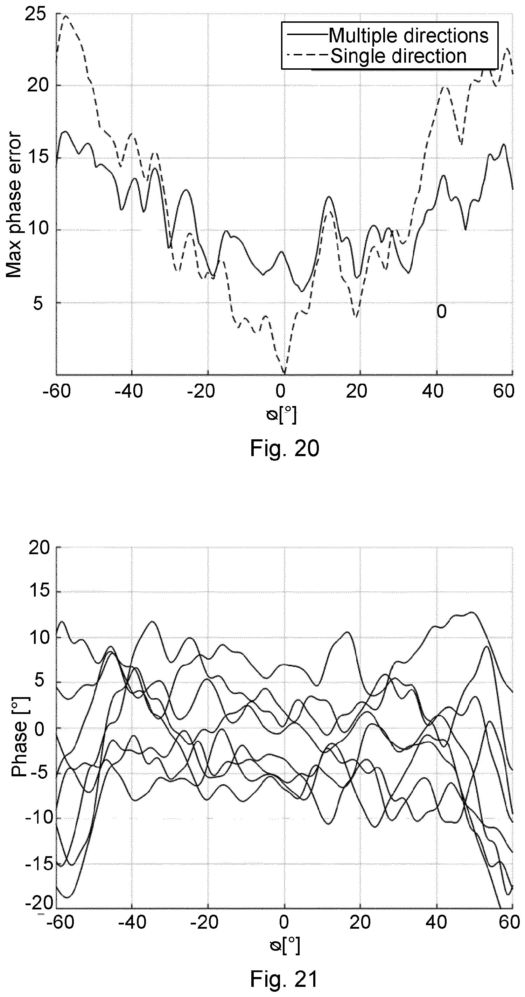

**Fig. 20** compares phase error boresight calibration and calibration resulting from least squares optimization in the 9 directions of Fig. 18 has been applied.

Fig. 21, Fig. 22, and Fig. 23 present results using a random uniform quiet zone phase error of +/-7.5°.

**Fig. 21** shows the phase after calibration in a single direction including a random uniform quiet zone phase error of +/-7.5°.

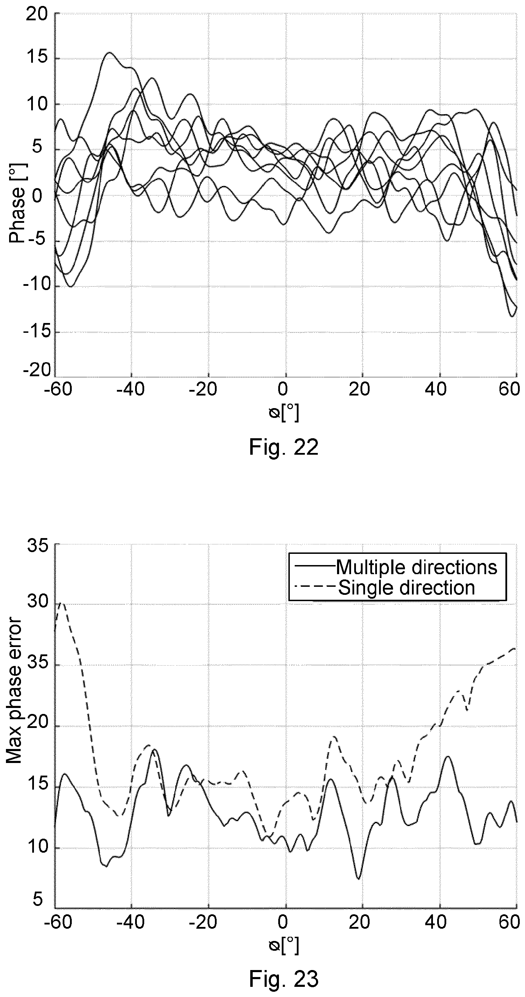

**Fig. 22** shows the phase after calibration in 9 directions (including quiet zone phase errors).

**Fig. 23** compares phase error after calibration (including quiet zone phase errors) for calibration in single direction and multiple directions.

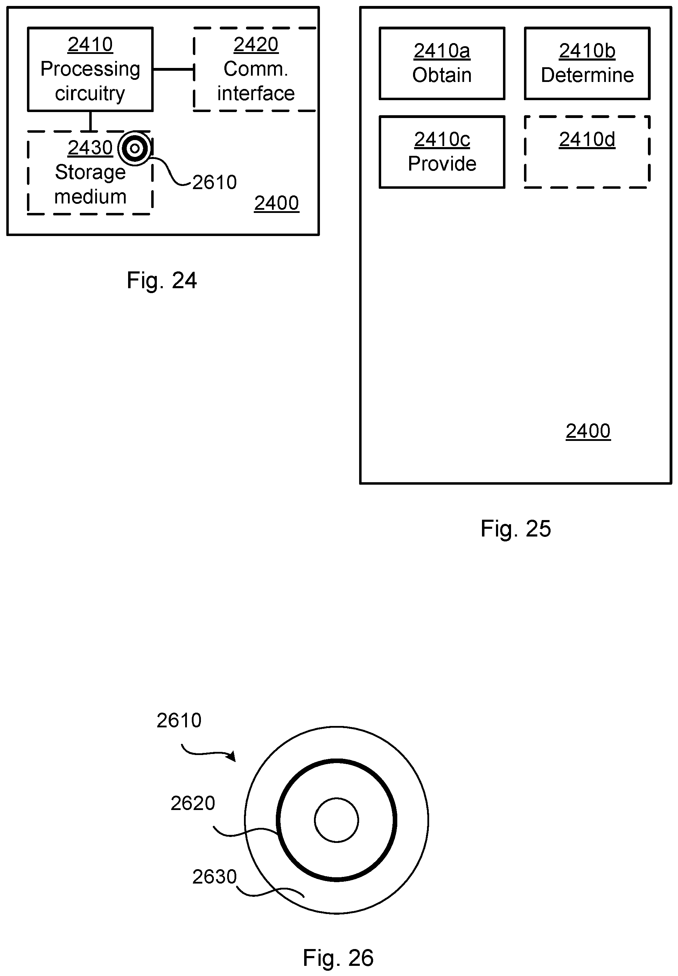

**Fig. 24** schematically illustrates, in terms of a number of functional units, the components of a test equipment 2400 according to an embodiment. Processing circuitry 2410 is provided using any combination of one or more of a suitable central processing unit (CPU), multiprocessor, microcontroller, digital signal processor (DSP), etc., capable of executing software instructions stored in a computer program product 2610 (as in Fig. 26), e.g. in the form of a storage medium 2430. The processing circuitry 2410 may further be provided as at least one application specific integrated circuit (ASIC), or field programmable gate array (FPGA).

Particularly, the processing circuitry 2410 is configured to cause the test equipment 2400 to perform a set of operations, or steps, as disclosed above. For example, the storage medium 2430 may store the set of operations, and the processing circuitry 2410 may be configured to retrieve the set of operations from the storage medium 2430 to cause the test equipment 2400 to perform the set of operations. The set of operations may be provided as a set of executable instructions.

Thus the processing circuitry 2410 is thereby arranged to execute methods as herein disclosed. The storage medium 2430 may also comprise persistent storage, which, for example, can be any single one or combination of magnetic memory, optical memory, solid state memory or even remotely mounted memory. The test equipment 2400 may further comprise a communications interface 2420 at least configured for communications with the AAS 910. As such the communications interface 2420 may comprise one or more transmitters and receivers, comprising analogue and digital components. The processing circuitry 2410 controls the general operation of the test equipment 2400 e.g. by sending data and control signals to the communications interface 2420 and the storage medium 2430, by receiving data and reports from the communications interface 2420, and by retrieving data and instructions from the storage medium 2430. Other components, as well as the related functionality, of the test equipment 2400 are omitted in order not to obscure the concepts presented herein.

**Fig. 25** schematically illustrates, in terms of a number of functional modules, the components of a test equipment 2400 according to an embodiment. The test equipment 2400 of Fig. 25 comprises a number of functional modules; an obtain module 2410a configured to perform step S102, a determine module 2410b configured to perform step S104, and a provide module 2410c configured to perform step S106. The test equipment 2400 of Fig. 25 may further comprise a number of optional functional modules, as represented by functional module 2410d. In general terms, each functional module 2410a-2410d may in one embodiment be implemented only in hardware and in another embodiment with the help of software, i.e., the latter embodiment having computer program instructions stored on the storage medium 2430 which when run on the processing circuitry makes the test equipment 2400 perform the corresponding steps mentioned above in conjunction with Fig 25. It should also be mentioned that even though the modules correspond to parts of a computer program, they do not need to be separate modules therein, but the way in which they are implemented in software is dependent on the programming language used. Preferably, one or more or all functional modules 2410a-2410d may be implemented by the processing circuitry 2410, possibly in cooperation with the communications interface 2420 and/or the storage medium 2430. The processing circuitry 2410 may thus be configured to from the storage medium 2430 fetch instructions as provided by a functional module 2410a-2410d and to execute these instructions, thereby performing any steps as disclosed herein.

The test equipment 2400 may be provided as a standalone device or as a part of at least one further device. For example, the test equipment 2400 may be provided as part of the AAS 910. Alternatively, functionality of the test equipment 2400 may be distributed between at least two devices, or nodes.

Thus, a first portion of the instructions performed by the test equipment 2400 may be executed in a first device, and a second portion of the of the instructions performed by the test equipment 2400 may be executed in a second device; the herein disclosed embodiments are not limited to any particular number of devices on which the instructions performed by the test equipment 2400 may be executed. Hence, the methods according to the herein disclosed embodiments are suitable to be performed by a test equipment 2400 residing in a cloud computational environment. Therefore, although a single processing circuitry 2410 is illustrated in Fig. 24 the processing circuitry 2410 may be distributed among a plurality of devices, or nodes. The same applies to the functional modules 2410a-2410d of Fig. 25 and the computer program 2620 of Fig. 26.

**Fig. 26** shows one example of a computer program product 2610 comprising computer readable storage medium 2630. On this computer readable storage medium 2630, a computer program 2620 can be stored, which computer program 2620 can cause the processing circuitry 2410 and thereto operatively coupled entities and devices, such as the communications interface 2420 and the storage medium 2430, to execute methods according to embodiments described herein. The computer program 2620 and/or computer program product 2610 may thus provide means for performing any steps as herein disclosed.

In the example of Fig. 26, the computer program product 2610 is illustrated as an optical disc, such as a CD (compact disc) or a DVD (digital versatile disc) or a Blu-Ray disc. The computer program product 2610 could also be embodied as a memory, such as a random access memory (RAM), a read-only memory (ROM), an erasable programmable read-only memory (EPROM), or an electrically erasable programmable read-only memory (EEPROM) and more particularly as a non-volatile storage medium of a device in an external memory such as a USB (Universal Serial Bus) memory or a Flash memory, such as a compact Flash memory. Thus, while the computer program 2620 is here schematically shown as a track on the depicted optical disk, the computer program 2620 can be stored in any way which is suitable for the computer program product 2610.

The inventive concept has mainly been described above with reference to a few embodiments. However, as is readily appreciated by a person skilled in the art, other embodiments than the ones disclosed above are equally possible within the scope of the inventive concept, as defined by the appended patent claims.

## Claims

1. A method for over the air, OTA, calibration of an advanced antenna system, AAS, (910), the advanced antenna system (910) comprising N antenna branches (960), each of which comprises a respective subarray (970a:970N), where the subarray of each antenna branch has a subarray antenna pattern (100; *g*₁(*θ*, *ϕ*), *g*₂(*θ*, *ϕ*), ..., *g_{N}*(*θ, ϕ*)) extending over an angular interval, the method being performed by a test equipment (2400), the method comprising:
obtaining (S102) measurement values for each of the antenna branches, wherein at least one measurement value is obtained per each antenna branch;
determining (S104) one calibration factor value (*c_{n,dB}*, *c_{n,deg}*) per antenna branch using the measurement values and taking the subarray antenna patterns (100; *g*₁(*θ*, *ϕ*), *g*₂(*θ*, *ϕ*), ..., *g_{N}*(*θ, ϕ*)) into account, wherein each of the antenna branches (960) is coupled to a transmitter (*tₙ*) and a receiver (*rₙ*) that are affected by the calibration factor value (*c_{n,dB}*, *c_{n,deg}*); and
applying (S106) the determined calibration factor values to the N antenna branches (960), thereby calibrating the AAS (910).

2. The method according to claim 1, wherein the measurement values pertain to at least one of amplitude and phase.

3. The method according to claim 1 or 2, wherein the subarray antenna patterns are known to the test equipment (2400).

4. The method according to claim 3, wherein all measurement values are obtained from one and the same direction within the angular interval.

5. The method according to claim 4, wherein the calibration factor value (*c_{n,dB}*, *c_{n,deg}*) per antenna branch is determined as a function of a reference signal value given by *Y_{ref}*, the subarray antenna pattern for the subarray of antenna branch n in direction *ϕ* given by ${g}_{n} \left({ϕ}_{cal}^{m}\right)$, and a received signal value for antenna branch *n* in direction *ϕ* given by ${Y}_{n} \left({ϕ}_{cal}^{m}\right)$.

6. The method according to claim 5, wherein, in terms of amplitude variation, the calibration factor value for antenna branch n is determined as: ${c}_{n , dB} = 20 log \left|\frac{{Y}_{ref} ⋅ {g}_{n} \left({ϕ}_{cal}^{m}\right)}{{Y}_{n} \left({ϕ}_{cal}^{m}\right)}\right|$

7. The method according to claim 5 or 6, wherein, in terms of phase variation, the calibration factor value for antenna branch n is determined as: ${c}_{n , deg} = arg \left(\frac{{Y}_{ref} ⋅ {g}_{n} \left({ϕ}_{cal}^{m}\right)}{{Y}_{n} \left({ϕ}_{cal}^{m}\right)}\right)$

8. The method according to claim 3, wherein measurement values for each of the subarray antenna patterns are obtained from one and the same set of directions, the set of directions being composed of at least two directions within the angular interval.

9. The method according to claim 8, wherein, in terms of amplitude variation, the calibration factor value *c_{n,dB}* for antenna branch *n* is determined as a function of magnitude of a received signal value of the measurement values for antenna branch n in a direction *ϕ* given by ${Y}_{n , dB} \left({ϕ}_{cal}^{m}\right)$, the amplitude-wise subarray antenna pattern for subarray *n* in a direction *ϕ* given by ${g}_{n , dB} \left({ϕ}_{cal}^{m}\right)$, and an amplitude-wise reference signal value given by *P_{ref,dB}*.

10. The method according to claim 9 wherein, in terms of amplitude variation, the calibration factor value *c_{n,dB}* for antenna branch *n* is determined by minimizing a cost function *S*(*c_{n,dB}*) given as: $S \left({c}_{n , dB}\right) = {\sum }_{m = 1}^{M} {\left(\left|{Y}_{n , dB}\left({ϕ}_{cal}^{m}\right)+{c}_{n , dB}-{g}_{n , dB}\left({ϕ}_{cal}^{m}\right)-{P}_{ref , dB}\right|\right)}^{2}$

11. The method according to claim 8, 9, or 10, wherein, in terms of phase variation, the calibration factor value *c_{n,deg}* for antenna branch *n* is determined as a function of a phase-wise received signal value of the measurement values for antenna branch n in a direction *ϕ* given by ${Y}_{n , deg} \left({ϕ}_{cal}^{m}\right)$, the phase-wise subarray antenna pattern for the subarray of antenna branch *n* in a direction *ϕ* given by ${g}_{n , deg} \left({ϕ}_{cal}^{m}\right)$, and a phase-wise reference signal value given by *P_{ref,deg}*.

12. The method according to claim 1 or 2, wherein the measurement values are of amplitude and/or phase values in at least two directions within the angular interval, and wherein the amplitude and/or phase values represent the subarray antenna patterns.

13. The method according to claim 12, wherein, in terms of amplitude variation, the calibration factor value *c_{n,dB}* for antenna branch *n* is determined as a function of magnitude of a received signal value of the measurement values for antenna branch n in a direction *ϕ* given by ${Y}_{n , dB} \left({ϕ}_{cal}^{m}\right)$ and an amplitude-wise reference signal value in a direction *ϕ* given by ${Y}_{ref , dB} \left({ϕ}_{cal}^{m}\right)$.

14. The method according to claim 12 or 13, wherein, in terms of phase variation, the calibration factor value *c_{n,deg}* for antenna branch *n* is determined as a function of a phase-wise received signal value of the measurement values for antenna branch n in a direction *ϕ* given by ${Y}_{n , deg} \left({ϕ}_{cal}^{m}\right)$ and a phase-wise reference signal value in a direction *ϕ* given by ${Y}_{ref , deg} \left({ϕ}_{cal}^{m}\right)$.

15. The method according to any of the preceding claims, wherein each subarray comprises at least one individual antenna element.

16. A test equipment (2400) for over the air, OTA, calibration of an advanced antenna system, AAS, (910), the advanced antenna system (910) comprising N antenna branches (960), each of which comprises a respective subarray (970a:970N), where the subarray of each antenna branch has a subarray antenna pattern (100; *g*₁(*θ*, *ϕ*), *g*₂(*θ*, *ϕ*), ..., *g_{N}*(*θ, ϕ*)) extending over an angular interval, the test equipment (2400) comprising processing circuitry (2410), the processing circuitry being configured to cause the test equipment (2400) to:
obtain measurement values for each of the antenna branches, wherein at least one measurement value is obtained per each antenna branch;
determine one calibration factor value (*c_{n,dB}, c_{n,deg}*) per antenna branch using the measurement values and taking the subarray antenna patterns (100; *g*₁(*θ, ϕ*), *g*₂(*θ, ϕ*), ..., *g_{N}*(*θ, ϕ*)) into account, wherein each of the antenna branches (960) is coupled to a transmitter (*tₙ*) and a receiver (*rₙ*) that are affected by the calibration factor value (*c_{n,dB}, c_{n,deg}*); and
apply the determined calibration factor values to the N antenna branches (960), thereby calibrating the AAS (910).

17. A computer program (2620) for over the air, OTA, calibration of an advanced antenna system, AAS, (910), the advanced antenna system (910) comprising N antenna branches (960), each of which comprises a respective subarray (970a:970N), where the subarray of each antenna branch has a subarray antenna pattern (100; *g*₁(*θ, ϕ*), *g*₂(*θ*, *ϕ*), ..., *g_{N}*(*θ, ϕ*)) extending over an angular interval, the computer program comprising computer code which, when run on processing circuitry (2410) of a test equipment (2400), causes the test equipment (2400) to:
obtain (S102) measurement values for each of the antenna branches, wherein at least one measurement value is obtained per each antenna branch;
determine (S104) one calibration factor value (*c_{n,dB}, c_{n,deg}*) per antenna branch using the measurement values and taking the subarray antenna patterns (100; *g*₁(*θ, ϕ*), *g*₂(*θ, ϕ*), ..., *g_{N}*(*θ, ϕ*)) into account, wherein each of the antenna branches (960) is coupled to a transmitter (*tₙ*) and a receiver (*rₙ*) that are affected by the calibration factor value (*c_{n,dB}*, *c_{n,deg}*); and
apply (S106) the determined calibration factor values to the N antenna branches (960), thereby calibrating the AAS (910).

## Patentansprüche

1. Verfahren zur Over-the-Air-Kalibrierung, OTA-Kalibrierung, eines fortschrittlichen Antennensystems, AAS, (910), wobei das fortschrittliche Antennensystem (910) N Antennenzweige (960) umfasst, die jeweils ein jeweiliges Subarray (970a:970N) umfassen, wobei das Subarray jedes Antennenzweigs ein Subarray-Antennenmuster (100; *g*₁(*θ, φ*), *g*₂(*θ, φ*), ..., *g_{N}*(*θ, φ*)) aufweist, das sich über ein Winkelintervall erstreckt, wobei das Verfahren von einer Prüfeinrichtung (2400) durchgeführt wird und wobei das Verfahren Folgendes umfasst:
Erhalten (S102) von Messwerten für jeden der Antennenzweige, wobei mindestens ein Messwert pro Antennenzweig erhalten wird;
Bestimmen (S104) eines Kalibrierungsfaktorwerts (*c_{n,dB}, c_{n,deg}*) pro Antennenzweig unter Verwendung der Messwerte und unter Berücksichtigung der Subarray-Antennenmuster (100; *g*₁(*θ, φ*), *g*₂(*θ, φ*), ..., *g_{N}*(*θ, φ*)), wobei jeder der Antennenzweige (960) mit einem Sender (*tₙ*) und einem Empfänger (*rₙ*) gekoppelt ist, die von dem Kalibrierungsfaktorwert (*c_{n, dB}, c_{n, deg}*) beeinflusst werden; und
Anwenden (S106) des bestimmten Kalibrierungsfaktorwerts auf die N Antennenzweige (960), um dadurch das AAS (910) zu kalibrieren.

2. Verfahren nach Anspruch 1, wobei die Messwerte mindestens eine von Amplitude und Phase betreffen.

3. Verfahren nach Anspruch 1 oder 2, wobei die Subarray-Antennenmuster der Prüfeinrichtung (2400) bekannt sind.

4. Verfahren nach Anspruch 3, wobei alle Messwerte aus ein- und derselben Richtung innerhalb des Winkelintervalls erhalten werden.

5. Verfahren nach Anspruch 4, wobei der Kalibrierungsfaktorwert (*c_{n, dB}*, *c_{n, deg}*) pro Antennenzweig als Funktion eines Referenzsignalwerts, gegeben durch *Y_{ref},* des Subarray-Antennenmusters für das Subarray von Antennenzweig n in Richtung *φ*, gegeben durch ${g}_{n} \left({ϕ}_{cal}^{m}\right)$, und eines Empfangssignalwerts für Antennenzweig n in Richtung *φ*, gegeben durch ${Y}_{n} \left({ϕ}_{cal}^{m}\right)$, bestimmt wird.

6. Verfahren nach Anspruch 5, wobei der Kalibrierungsfaktorwert für Antennenzweig n bezüglich Amplitudenvariation bestimmt wird als: ${c}_{n , dB} = 20 log \left|\frac{{Y}_{ref} ⋅ {g}_{n} \left({ϕ}_{cal}^{m}\right)}{{Y}_{n} \left({ϕ}_{cal}^{m}\right)}\right|$

7. Verfahren nach Anspruch 5 oder 6, wobei der Kalibrierungsfaktorwert für Antennenzweig n bezüglich Phasenvariation bestimmt wird als: ${c}_{n , deg} = arg \left(\frac{{Y}_{ref} ⋅ {g}_{n} \left({ϕ}_{cal}^{m}\right)}{{Y}_{n} \left({ϕ}_{cal}^{m}\right)}\right)$

8. Verfahren nach Anspruch 3, wobei Messwerte für jedes der Subarray-Antennenmuster aus ein- und demselben Satz von Richtungen erhalten werden, wobei der Satz von Richtungen aus mindestens zwei Richtungen innerhalb des Winkelintervalls besteht.

9. Verfahren nach Anspruch 8, wobei der Kalibrierungsfaktorwert *cₙ, _{dB}* für Antennenzweig *n* bezüglich Amplitudenvariation als Funktion der Größe eines Empfangssignalwerts der Messwerte für Antennenzweig n in einer Richtung *φ*, gegeben durch ${Y}_{n , dB} \left({ϕ}_{cal}^{m}\right)$, des amplitudenweisen Subarray-Antennenmusters für Subarray *n* in einer Richtung Φ, gegeben durch ${g}_{n , dB} \left({ϕ}_{cal}^{m}\right)$, und eines amplitudenweisen Referenzsignalwerts, gegeben durch *P_{ref, dB},* bestimmt wird.

10. Verfahren nach Anspruch 9, wobei der Kalibrierungsfaktorwert *c_{n, dB}* für Antennenzweig n bezüglich Amplitudenvariation bestimmt wird durch Minimieren einer Kostenfunktion *S*(*c_{n, dB}*), gegeben als: $S \left({c}_{n , dB}\right) = {\sum }_{m = 1}^{M} {\left(\left|{Y}_{n , dB}\left({ϕ}_{cal}^{m}\right)+{c}_{n , dB}-{g}_{n , dB}\left({ϕ}_{cal}^{m}\right)-{P}_{ref , dB}\right|\right)}^{2}$

11. Verfahren nach Anspruch 8, 9 oder 10, wobei der Kalibrierungsfaktorwert *c_{n, deg}* für Antennenzweig *n* bezüglich Phasenvariation als Funktion eines phasenweisen Empfangssignalwerts der Messwerte für Antennenzweig n in einer Richtung *φ*, gegeben durch ${Y}_{n , deg} \left({ϕ}_{cal}^{m}\right)$, des phasenweisen Subarray-Antennenmusters für das Subarray von Antennenzweig n in einer Richtung *φ*, gegeben durch ${g}_{n , deg} \left({ϕ}_{cal}^{m}\right)$, und eines phasenweisen Referenzsignalwerts, gegeben durch *P_{ref, deg},* bestimmt wird.

12. Verfahren nach Anspruch 1 oder 2, wobei die Messwerte von Amplituden- und/oder Phasenwerten in mindestens zwei Richtungen innerhalb des Winkelintervalls sind und wobei die Amplituden- und/oder Phasenwerte die Subarray-Antennenmuster darstellen.

13. Verfahren nach Anspruch 12, wobei der Kalibrierungsfaktorwert *c_{n, dB}* für Antennenzweig *n* bezüglich Amplitudenvariation als Funktion der Größe eines Empfangssignalwerts der Messwerte für Antennenzweig n in einer Richtung *φ*, gegeben durch ${Y}_{n , dB} \left({ϕ}_{cal}^{m}\right)$, und eines amplitudenweisen Referenzsignalwerts in einer Richtung *φ*, gegeben durch ${Y}_{ref , dB} \left({ϕ}_{cal}^{m}\right)$, bestimmt wird.

14. Verfahren nach Anspruch 12 oder 13, wobei der Kalibrierungsfaktorwert *c_{n, deg}* für Antennenzweig *n* bezüglich Phasenvariation als Funktion eines phasenweisen Empfangssignalwerts der Messwerte für Antennenzweig n in einer Richtung *φ*, gegeben durch ${Y}_{n , deg} \left({ϕ}_{cal}^{m}\right)$, und eines phasenweisen Referenzsignalwerts in einer Richtung *φ*, gegeben durch ${Y}_{ref , deg} \left({ϕ}_{cal}^{m}\right)$, bestimmt wird.

15. Verfahren nach einem der vorhergehenden Ansprüche, wobei jedes Subarray mindestens ein einzelnes Antennenelement umfasst.

16. Prüfvorrichtung (2400) für Over-the-Air-Kalibrierung, OTA-Kalibrierung, eines fortschrittlichen Antennensystems, AAS, (910), wobei das fortschrittliche Antennensystem (910) N Antennenzweige (960) umfasst, die jeweils ein jeweiliges Subarray (970a:970N) umfassen, wobei das Subarray jedes Antennenzweigs ein Subarray-Antennenmuster (100; *g*₁(*θ, φ*), *g*₂(*θ, φ*), ..., *g_{N}*(*θ*, *φ*)) aufweist, das sich über ein Winkelintervall erstreckt, wobei die Prüfeinrichtung (2400) Verarbeitungsschaltungsanordnung (2410) umfasst, wobei die Verarbeitungsschaltungsanordnung dazu ausgelegt ist, die Prüfvorrichtung (2400) zu Folgendem zu veranlassen:
Erhalten von Messwerten für jeden der Antennenzweige, wobei mindestens ein Messwert pro Antennenzweig erhalten wird;
Bestimmen eines Kalibrierungsfaktorwerts (*c_{n,dB}, c_{n,deg}*) pro Antennenzweig unter Verwendung der Messwerte und unter Berücksichtigung der Subarray-Antennenmuster *(100; g*₁(*θ, φ*), *g*₂(*θ, φ*), ..., *g_{N}*(*θ, φ*)), wobei jeder der Antennenzweige (960) mit einem Sender (*tₙ*) und einem Empfänger (*rₙ*) gekoppelt ist, die von dem Kalibrierungsfaktorwert (*c_{n,dB}, c_{n,deg}*) beeinflusst werden; und
Anwenden des bestimmten Kalibrierungsfaktorwerts auf die N Antennenzweige (960), um dadurch das AAS (910) zu kalibrieren.

17. Computerprogramm (2620) für Over-the-Air-Kalibrierung, OTA-Kalibrierung, eines fortschrittlichen Antennensystems, AAS, (910), wobei das fortschrittliche Antennensystem (910) N Antennenzweige (960) umfasst, die jeweils ein jeweiliges Subarray (970a:970N) umfassen, wobei das Subarray jedes Antennenzweigs ein Subarray-Antennenmuster (100; *g*₁(*θ, φ*), *g*₂(*θ, φ*), ..., *g_{N}*(*θ, φ*)) aufweist, das sich über ein Winkelintervall erstreckt, wobei das Computerprogramm Computercode umfasst, der bei Ausführung auf Verarbeitungsschaltungsanordnung (2410) einer Prüfvorrichtung (2400) die Prüfvorrichtung (2400) zu Folgendem veranlasst:
Erhalten (S102) von Messwerten für jeden der Antennenzweige, wobei mindestens ein Messwert pro Antennenzweig erhalten wird;
Bestimmen (S104) eines Kalibrierungsfaktorwerts (*c_{n,dB}, c_{n,deg}*) pro Antennenzweig unter Verwendung der Messwerte und unter Berücksichtigung der Subarray-Antennenmuster (100; *g*₁(*θ, φ*), *g*₂(*θ, φ*), ..., *g_{N}*(*θ, φ*)), wobei jeder der Antennenzweige (960) mit einem Sender (tₙ) und einem Empfänger (rₙ) gekoppelt ist, die von dem Kalibrierungsfaktorwert (*c_{n,dB}, c_{n,deg}*) beeinflusst werden; und
Anwenden (S106) des bestimmten Kalibrierungsfaktorwerts auf die N Antennenzweige (960), um dadurch das AAS (910) zu kalibrieren.

## Revendications

1. Procédé d'étalonnage par liaison radio, OTA, d'un système d'antenne évolué, AAS, (910), le système d'antenne évolué (910) comprenant N branches d'antenne (960), chacune d'elles comprenant un sous-réseau (970a:970N) respectif, où le sous-réseau de chaque branche d'antenne présente un motif d'antenne de sous-réseau (100 ; *g*₁(*θ, ϕ*), *g*₂(*θ, ϕ*), ..., *g_{N}*(*θ, ϕ*)) s'étendant sur un intervalle angulaire, le procédé étant réalisé par un équipement de test (2400), le procédé comprenant :
l'obtention (S102) de valeurs de mesure pour chacune des branches d'antenne, dans lequel au moins une valeur de mesure est obtenue par chaque branche d'antenne ;
la détermination (S104) d'une valeur de facteur d'étalonnage (*c_{n,dB}, c_{n,deg}*) par branche d'antenne à l'aide des valeurs de mesure et en tenant compte des motifs d'antenne de sous-réseau (100 ; *g*₁(*θ, ϕ*), *g*₂(*θ, ϕ*), ..., *g_{N}*(*θ, ϕ*)), dans lequel chacune des branches d'antenne (960) est couplée à un émetteur (*tₙ*) et à un récepteur (*rₙ*) qui sont affectés par la valeur de facteur d'étalonnage (*c_{n,dB}, c_{n,deg}*) ; et
l'application (S106) des valeurs de facteur d'étalonnage déterminées aux N branches d'antenne (960), étalonnant ainsi l'AAS (910).

2. Procédé selon la revendication 1, dans lequel les valeurs de mesure concernent au moins l'une parmi une amplitude et une phase.

3. Procédé selon la revendication 1 ou 2, dans lequel les motifs d'antenne de sous-réseau sont connus par l'équipement de test (2400).

4. Procédé selon la revendication 3, dans lequel toutes les valeurs de mesure sont obtenues à partir d'une seule et même direction à l'intérieur de l'intervalle angulaire.

5. Procédé selon la revendication 4, dans lequel la valeur de facteur d'étalonnage (*c_{n,dB}, c_{n,deg}*) par branche d'antenne est déterminée en fonction d'une valeur de signal de référence donnée par *Y_{ref},* du motif d'antenne de sous-réseau pour le sous-réseau d'une branche d'antenne *n* dans une direction *ϕ* donnée par ${g}_{n} \left({ϕ}_{cal}^{m}\right)$, et d'une valeur de signal reçue pour une branche d'antenne *n* dans une direction *ϕ* donnée par ${Y}_{n} \left({ϕ}_{cal}^{m}\right)$.

6. Procédé selon la revendication 5, dans lequel, en termes de variation d'amplitude, la valeur de facteur d'étalonnage pour une branche d'antenne n est déterminée par : ${c}_{n , dB} = 20 log \left|\frac{{Y}_{ref} ⋅ {g}_{n} \left({ϕ}_{cal}^{m}\right)}{{Y}_{n} \left({ϕ}_{cal}^{m}\right)}\right| .$

7. Procédé selon la revendication 5 ou 6, dans lequel, en termes de variation de phase, la valeur de facteur d'étalonnage pour une branche d'antenne n est déterminée par : ${c}_{n , deg} = arg \left|\frac{{Y}_{ref} ⋅ {g}_{n} \left({ϕ}_{cal}^{m}\right)}{{Y}_{n} \left({ϕ}_{cal}^{m}\right)}\right|$

8. Procédé selon la revendication 3, dans lequel des valeurs de mesure pour chacun des motifs d'antenne de sous-réseau sont obtenues à partir d'un seul et même ensemble de directions, l'ensemble de directions se composant d'au moins deux directions à l'intérieur de l'intervalle angulaire.

9. Procédé selon la revendication 8, dans lequel, en termes de variation d'amplitude, la valeur de facteur d'étalonnage *c_{n,dB}* pour une branche d'antenne *n* est déterminée en fonction d'une grandeur d'une valeur de signal reçue des valeurs de mesure pour une branche d'antenne *n* dans une direction *ϕ* donnée par ${Y}_{n , dB} \left({ϕ}_{cal}^{m}\right)$, du motif d'antenne de sous-réseau amplitude par amplitude pour un sous-réseau n dans une direction *ϕ* donnée par ${g}_{n , dB} \left({ϕ}_{cal}^{m}\right)$, et d'une valeur de signal de référence amplitude par amplitude donnée par *P_{ref,dB}*.

10. Procédé selon la revendication 9, dans lequel, en termes de variation d'amplitude, la valeur de facteur d'étalonnage *c_{n,dB}* pour une branche d'antenne *n* est déterminée par la minimisation d'une fonction de coût *S*(*c_{n,dB}*) donnée par : $S \left({c}_{n , dB}\right) = {\sum }_{m = 1}^{M} {\left(\left|{Y}_{n , dB}\left({ϕ}_{cal}^{m}\right)+{C}_{n , dB}-{g}_{n , dB}\left({ϕ}_{cal}^{m}\right)-{P}_{ref , dB}\right|\right)}^{2}$

11. Procédé selon la revendication 8, 9 ou 10, dans lequel, en termes de variation de phase, la valeur de facteur d'étalonnage *c_{n,deg}* pour une branche d'antenne *n* est déterminée en fonction d'une valeur de signal reçue phase par phase des valeurs de mesure pour une branche d'antenne n dans une direction *ϕ* donnée par ${Y}_{n , deg} \left({ϕ}_{cal}^{m}\right)$, du motif d'antenne de sous-réseau phase par phase pour le sous-réseau d'une branche d'antenne n dans une direction *ϕ* donnée par ${g}_{n , deg} \left({ϕ}_{cal}^{m}\right)$, et d'une valeur de signal de référence phase par phase donnée par *P_{ref,deg}*.

12. Procédé selon la revendication 1 ou 2, dans lequel les valeurs de mesure sont des valeurs d'amplitude et/ou de phase dans au moins deux directions à l'intérieur de l'intervalle angulaire, et dans lequel les valeurs d'amplitude et/ou de phase représentent les motifs d'antenne de sous-réseau.

13. Procédé selon la revendication 12, dans lequel, en termes de variation d'amplitude, la valeur de facteur d'étalonnage *c_{n,dB}* pour une branche d'antenne *n* est déterminée en fonction d'une grandeur d'une valeur de signal reçue des valeurs de mesure pour une branche d'antenne *n* dans une direction *ϕ* donnée par ${Y}_{n , dB} \left({ϕ}_{cal}^{m}\right)$ et d'une valeur de signal de référence amplitude par amplitude dans une direction *ϕ* donnée par ${Y}_{ref , dB} \left({ϕ}_{cal}^{m}\right)$.

14. Procédé selon la revendication 12 ou 13, dans lequel, en termes de variation de phase, la valeur de facteur d'étalonnage *c_{n,deg}* pour une branche d'antenne *n* est déterminée en fonction d'une valeur de signal reçue phase par phase des valeurs de mesure pour une branche d'antenne *n* dans une direction *ϕ* donnée par ${Y}_{n , deg} \left({ϕ}_{cal}^{m}\right)$ et d'une valeur de signal de référence phase par phase dans une direction *ϕ* donnée par ${Y}_{ref , deg} \left({ϕ}_{cal}^{m}\right)$*.*

15. Procédé selon l'une quelconque des revendications précédentes, dans lequel chaque sous-réseau comprend au moins un élément d'antenne individuel.

16. Equipement de test (2400) pour un étalonnage par liaison radio, OTA, d'un système d'antenne évolué, AAS, (910), le système d'antenne évolué (910) comprenant N branches d'antenne (960), chacune d'elles comprenant un sous-réseau (970a:970N) respectif, où le sous-réseau de chaque branche d'antenne présente un motif d'antenne de sous-réseau (100 ; *g*₁(*θ, ϕ*), *g*₂(*θ, ϕ*), ..., *g_{N}*(*θ, ϕ*)) s'étendant sur un intervalle angulaire, l'équipement de test (2400) comprenant une circuiterie de traitement (2410), la circuiterie de traitement étant configurée pour amener l'équipement de test (2400) à :
obtenir des valeurs de mesure pour chacune des branches d'antenne, dans lequel au moins une valeur de mesure est obtenue par chaque branche d'antenne ;
déterminer une valeur de facteur d'étalonnage (*c_{n,dB}, c_{n,deg}*) par branche d'antenne à l'aide des valeurs de mesure et en tenant compte des motifs d'antenne de sous-réseau (100 ; *g*₁(*θ, ϕ*), *g*₂(*θ, ϕ*), *..., g_{N}*(*θ*, *ϕ*)), dans lequel chacune des branches d'antenne (960) est couplée à un émetteur (*tₙ*) et à un récepteur (*rₙ*) qui sont affectés par la valeur de facteur d'étalonnage (*c_{n,dB}, c_{n,deg}*) ; et
appliquer les valeurs de facteur d'étalonnage déterminées aux N branches d'antenne (960), étalonnant ainsi l'AAS (910).

17. Programme informatique (2620) pour un étalonnage par liaison radio, OTA, d'un système d'antenne évolué, AAS, (910), le système d'antenne évolué (910) comprenant N branches d'antenne (960), chacune d'elles comprenant un sous-réseau (970a:970N) respectif, où le sous-réseau de chaque branche d'antenne présente un motif d'antenne de sous-réseau (100 ; *g*₁(*θ, ϕ*), *g*₂(*θ, ϕ*)*,* ..., *g_{N}*(*θ, ϕ*)) s'étendant sur un intervalle angulaire, le programme informatique comprenant un code informatique qui, lorsqu'il est exécuté sur une circuiterie de traitement (2410) d'un équipement de test (2400), amène l'équipement de test (2400) à :
obtenir (S102) des valeurs de mesure pour chacune des branches d'antenne, dans lequel au moins une valeur de mesure est obtenue par chaque branche d'antenne ;
déterminer (S104) une valeur de facteur d'étalonnage (*c_{n,dB}, c_{n,deg}*) par branche d'antenne à l'aide des valeurs de mesure et en tenant compte des motifs d'antenne de sous-réseau (100 ; *g*₁(*θ, ϕ*), *g*₂(*θ*, *ϕ*), ..., *g_{N}*(*θ, ϕ*)), dans lequel chacune des branches d'antenne (960) est couplée à un émetteur (*tₙ*) et à un récepteur (*rₙ*) qui sont affectés par la valeur de facteur d'étalonnage (*c_{n,dB}, c_{n,deg}*) ; et
appliquer (S106) les valeurs de facteur d'étalonnage déterminées aux N branches d'antenne (960), étalonnant ainsi l'AAS (910).
